# EUROPEAN PATENT APPLICATION

(11) **EP 1 887 033 A1**
(43) Date of publication of application: **13.02.2008**
(21) Application number: 07015509.8
(22) Date of filing: 07.08.2007
(51) Int. Cl.: C08K 3/00, H01L 23/373, H01L 23/42, H01L 23/29, C09J 11/04

(54) **Thermally conductive material**

(30) Priority: 10.08.2006 US 502708
(71) Applicant: National Starch and Chemical Investment Holding Corporation, New Castle, Delaware 19720 (US)
(72) Inventor: Ruyters, Michel, 3980 Tessenderlo (BE); Bosmans, Chris, 3920 Lommel (BE)
(74) Representative: Held, Stephan

(57) **Abstract**

A low viscosity composition for use in varying applications, such as an encapsulant, anti-corrosive, adhesive and/or thermal interface material in an electronic device is provided. The composition comprises a blend one or more resins, one or more curing agents, one or more reactive diluents and one or more thermally conductive filler having particles with a high aspect ratio.

## Description

### FIELD OF THE INVENTION

This invention relates to a thermally conductive material that is utilized to encapsulate electronic components, bond electronic components and/or transfer heat from a heat-generating electronic device to a cold sink that absorbs and dissipates the transferred heat.

### BACKGROUND OF THE INVENTION

The invention described herein relates to low viscosity, thermally conductive, electrically insulating paste compositions which are utilized in various electronic applications such as encapsulation of electronic devices, bonding heat dissipating components to a printed wiring board, bonding printed wiring board to heat sinks or any other application in which thermal conductivity is required.

In addition to the protection of the electronic devices, these compositions serve also to mechanically fix the components and to manage thermal transfer of electronic device. Electronic devices, such as those containing semiconductors, typically generate a significant amount of heat during operation. In order to cool the semiconductors, cold sinks are typically affixed in some manner to the device. In operation, heat generated during use is transferred from the semiconductor to the cold sink where the heat is harmlessly dissipated. In order to maximize the heat transfer from the semiconductor to the cold sink, a thermally conductive thermal interface material is utilized. The thermal interface material ideally provides an intimate contact between the cold sink and the semiconductor to facilitate the heat transfer.

A class of traditionally used thermal interface materials is thermally conductive film or sheets, greases or phase change materials. Although such materials provide high thermal conductivity, they most often must be combined with an additional mechanical fixation such as screws or clips to hold the components in place.

Another class of thermal interface materials is organic thermoplastic or thermosetting organic binders filled with metals such as silver, gold, aluminum, nickel, copper and the like. The thermal conductivity of these materials is generally high and in the range of 3-5W/mK, but they cannot be used in those applications where electrical insulation is needed.

Currently available dispensable or printable electrically insulating thermal interface materials have a thermal conductivity of 1-1.5 W/mK. With the higher thermal conductivity, they are no longer dispensable or printable.

It would be advantageous to provide a low viscosity, electrically insulating composition that would provide enhanced thermal conductivity over the currently available compositions.

### SUMMARY OF THE INVENTION

The present invention discloses a low viscosity thermosetting composition for use as an encapsulant, adhesive and/or thermal interface material in an electronic device. The composition comprises a blend one or more resins, one or more curing agents, one or more reactive diluents and one or more thermally conductive fillers.

In one embodiment the composition has a low viscosity to enable dispensing or stencil printing.

In a further embodiment, the present invention provides a thermosetting composition comprising in the range of about 5 to about 40 weight % organic matter and in the range of about 60 to about 95 weight % thermally conductive particles.

Another aspect of the present invention provides an electronic device containing a material according to the above description.

### DETAILED DESCRIPTION OF THE INVENTION

The material of the present invention may be utilized with virtually any electronic component for many varying applications, including those in which it is desired to provide encapsulant protection, corrosion protection, adherence between one or more components, and/or dissipation of heat. In particular, the material is useful for providing protection for connections and components in electronic devices and for aiding in the dissipation of heat from heat-generating components in such devices. In addition, the material is useful in applications, such as ink jet printers, wherein electronic components require protection from corrosion caused by exposure to harsh materials such as ink and water with various pH ranges. The material may also be utilized as an adhesive paste to bond electronic components to a substrate, such as power diodes to a printed circuit board or a printed circuit board to a metal heat sink. When acting as a thermal interface material, the material frequently forms a layer between the heat-generating component and a cold sink and transfers the heat to be dissipated to the cold sink.

The demand for faster flowing, low viscosity board-level encapsulant or thermal transfer compositions is increasing. Low viscosity applications provide multiple processing advantages, including eliminating the requirement of heating the substrate before application and allowing easy dispensing or stencil printing. The elimination of the heating of the substrate results in increased manufacturing efficiency in the form of improved manufacturing throughput

The material comprises of the present invention comprises one or more curable resins, one or more curing agents and one or more thermally conductive filler which is free of sharp geometrical edges and has a large particle aspect ratio as measured by the ratio of length to the width of the particle.

Optionally, other materials such as reactive diluents, plasticizers, adhesion promoters, viscosity modifiers, pigments and the like may be incorporated in amounts necessary to produce the desired results.

Suitable curable resins may include resins such as epoxy, silicone, cyanate ester, bismaleimide, urethane, acrylate and combinations thereof. It is desirable that the viscosity at 25°C of the resins is below 3000 cps.

Examples of epoxy resins suitable for use in the present thermally conductive composition include liquid epoxies such as monofunctional and multifunctional glycidyl ethers of Bisphenol A and Bisphenol F, aliphatic and aromatic epoxies, saturated and unsaturated epoxies, phenolic epoxies, phenol novolac epoxies, non-glycidyl ether epoxy resins such as cycloaliphatic epoxy resins, or a combination thereof.

Glycidyl ether epoxies may be utilized in the material either separately or in combination with non-glycidyl ether epoxies. A preferred epoxy resin of this type is bisphenol A resin. Another preferred epoxy resin is bisphenol F type resin. A further preferred type of epoxy resin are epoxy functional butadiene acrylonitrile copolymers, epoxy functional polydimethyl siloxane and mixtures thereof may be employed as well. Commercially available bisphenol-F type resins are available from CVC Specialty Chemicals, Maple Shade, New Jersey, under the designation 8230E and Resolution Performance Products LLC under the designation RSL1739. Bisphenol-A type resin is commercially available from Resolution Technology such as EPON 828, and a blend of bisphenol-A and bisphenol-F is available from Nippon Chemical Company under the designation ZX-1059.

Examples of non-glycidyl ether epoxides include epoxidized diolefins, such as 3,4-epoxycyclohexylmethyl, 3,4-epoxycyclohexane carboxylate, which contains two epoxide groups that are part of the ring structures and an ester linkage, and bis (3,4-epoxycyclohexylmethyl adipate). Additional epoxies that may be utilized include vinylcyclohexene dioxide, which contains two epoxide groups and one of which is part of the ring structure, 3,4-epoxy-6-methyl cyclohexyl methyl-3,4-epoxycyclohexane carboxylate and dicyclopentadiene dioxide and mixtures thereof. Examples of commercially available non-glycidyl ether epoxides include ERL-4221 and ERL-4299, both commercially available from Dow Chemical Company. The one or more epoxy resin is typically used in an amount of between 20 weight percent to about 60 weight percent of the composition.

One or more curing agent is utilized in an amount effective to provide curing of the composition. In the case of epoxy resin, useful curing agents are amines, anhydrides, phenol compounds, dicyanediamine, blocked imidazoles. Particularly useful curing agents include substituted imidazoles such as 2-methylimidazole,2-phenylimidazole, 2-phenyl-4-methylimidazole, 2-ethyl-4-methylimidazole, 2-undecylimidazole, 1-benzyl-2-methylimidazole, 1-cyanoethyl-2-methylimidazole, 1-cyanoethyl-2-ethyl-4-methylimidazole.

The viscosity of the composition can be adjusted with diluents. It is generally preferred that the composition have a low viscosity to enable efficient dispensing or stencil printing of the composition. Exemplary reactive diluents that may be utilized, either separately or in combination, are glycidyl ethers, for example 1,4-butanediol diglycidyl ether; p-tert-butyl-phenyl glycidyl ether, allyl glycidyl ether, glycerol diglycidyl ether, glycidyl ether of alkyl phenol (commercially available from Cardolite Corporation as Cardolite NC513), although other diluents may be utilized.

The material further comprises thermally conductive particles. These particles are electrically non-conductive. Thermally conductive particles having smooth geometric surfaces and a high aspect ratio, i.e. having a length to width aspect ratio of greater than one, are utilized in the composition to provide enhanced thermal conductivity over particles that are spherical and/or have rough geometric edges. In one embodiment the aspect ratio of the particles is in the range of about 1 to 2.5. Particles having aspect ratios of greater than one provide in the range of about 20% more thermal conductivity than spherical or other shaped particles.

The thermally conductive particles may comprise any suitable thermally conductive material, including non-conductive fillers which may be added as desired to reduce the coefficient of thermal expansion of the adhesive. Exemplary thermally conductive fillers include silica, alumina, nano silica, nano alumina, zinc oxide, magnesium oxide, boron nitride, aluminum nitride, and mixtures thereof. Preferably, the thermally conductive particles are alumina.

The material of the invention preferably comprises between about 5 to about 40 weight % curable resin, between about 0.1 to about 30 weight % curing agents or catalysts, from about 25 to about 95 weight percent thermally conductive particles. Optionally the composition may contain about 2 to 20 weight % reactive diluents.

Additional ingredients, such as organic additives may be included in the formulation to provide desired properties. Various additives that may be included are surface active agents, surfactants, wetting agents, antioxidants, thixotropes, reinforcement materials, silane functional perfluoroether, phosphate functional perfluoroether, silanes, titanates, wax, phenol formaldehyde, air release agents, flow additives, adhesion promoters, rheology modifiers, surfactants, spacer beads and mixtures thereof. The ingredients are specifically chosen to obtain the desired balance of properties for the use of the resins utilized in the particular composition.

In a further embodiment of the present invention, a method of transferring heat between one or more components of an electronic device is provided. The method involves the steps of providing an electronic component and applying the composition of the present invention in the desired location such that it will effectively transfer any heat generated by one or more of the components. In a still further embodiment, an electronic component containing the composition of the present invention is provided.

The invention is further illustrated by the following non-limiting example:
Example. Seven samples of material were formed by the following process The epoxy resin blend was loaded into a planetary vacuum mixer together with the reactive diluent and mixed at medium shear for about 2-5 minutes. The curing agent or catalyst was added and mixed at medium shear. The thermally conductive component was added to the mixture in several increments. After each increment the mixture was stirred a medium to low shear. After the final increment was added, the mixture is stirred for about 30 - 60 minutes. The mixture was degassed by vacuum for 10-20 minutes under slow mixing. The formulation of the samples is set out in Table 1.

**Table 1. Sample formulations (all amounts are in weight percent)**

| Ingredient/Sample | 1 | 2 | 3 | 4 | 5 | 6 | 7 |
|---|---|---|---|---|---|---|---|
| Epoxy resin blend¹ | 15.19 | 12.79 | 12.00 | 11.20 | 11.20 | 11.20 | 11.20 |
| Diluent² | 3.25 | 2.74 | 2.57 | 2.40 | 2.40 | 2.40 | 2.40 |
| Catalyst³ | 0.91 | 0.64 | 0.60 | 0.56 | 0.56 | 0.56 | 0.56 |
| High Aspect Ratio Alumina⁴ | 80.00 | 83.00 | 84.00 | 85.00 | -- | -- | -- |
| Spherical Alumina⁵ | -- | -- | -- | -- | 85.00 | -- | -- |
| Spherical Alumina⁶ | -- | -- | -- | -- | -- | 85.0 | -- |
| Spherical Alumina⁷ | -- | -- | -- | -- | -- | -- | 85.0 |

| | | | | | | | |
|---|---|---|---|---|---|---|---|
| ¹Blend of Bisphenol A epoxy/amine adduct with a proprietary resin ²BDDGE, commercially available from Aldrich ³Blend of 2P4MZ and 2E4MZ imidazoles available from Aldrich ⁴AS-40, commercially available from Showa Denko ⁵DAB-20 SA, commercially available from Denki KKK ⁶DAB-30 S1, commercially available from Denki KKK ⁷DAB-45, commercially available from Denki KKK | | | | | | | |

The compositions of Table 1 were tested for viscosity on a constant shear rate rheometer and for thermal conductivity via the photoflash technique of ASTM E1461-01. The results of the viscosity and thermal conductivity tests are illustrated in Table 2.

**Table 2. Formulation Test Results**

| Sample | 1 | 2 | 3 | 4 | 5 | 6 | 7 |
|---|---|---|---|---|---|---|---|
| Thermal Conductivity (W/mK) | 1.94 | 2.27 | 2.31 | 2.55 | 2.03 | 2.10 | 1.80 |
| Viscosity (cps) | 19.6 | 32.2 | 40.8 | 87.9 | 37.6 | 71.0 | 92.0 |

As illustrated in Table 2, the compositions having the alumina filler with a high aspect ratio provide superior thermal conductivity than those containing spherical alumina filler. Further, the compositions having the high aspect ratio filler provide suitable low viscosity for the encapsulation, adhesive or thermal transfer applications for which they may be utilized.

Many modifications and variations of this invention can be made without departing from its spirit and scope, as will be apparent to those skilled in the art. The specific embodiments described herein are offered by way of example only, and the invention is to be limited only by the terms of the appended claims, along with the full scope of equivalents to which such claims are entitled.

## Claims

1. A thermally conductive composition comprising one or more curable resins, one or more curing agents, and thermally conductive particles, and optionally one or more diluents, wherein at least a portion of the thermally conductive particles have a high aspect ratio.

2. The composition of claim 1, wherein the one or more curable resins are selected from the group consisting of monofunctional and multifunctional glycidyl ethers of Bisphenol-A and Bisphenol-F, aliphatic and aromatic epoxies, saturated and unsaturated epoxies, phenolic epoxies, phenol novolac epoxies, non-glycidyl ether epoxy resins, cycloaliphatic epoxy resins, glycidyl ether epoxies, epoxy functional butadiene acrylonitrile, epoxy functional polydimethyl siloxane, epoxidized diolefins, vinylcyclohexene dioxide, 3,4-epoxy-6-methyl cyclohexyl methyl-3,4-epoxycyclohexane carboxylate and dicyclopentadiene dioxide silicone, cyanate ester, urethane, acrylate, bismaleimide or mixtures thereof.

3. The composition of claim 1, wherein the one or more curing agents are selected from the group consisting of amines, anhydrides, phenol compounds, dicyanediamine, blocked imidazoles, 2-methylimidazole,2-phenylimidazole, 2-phenyl-4-methylimidazole, 2-ethyl-4-methylimidazole, 2-undecylimidazole, 1-benzyl-2-methylimidazole, 1-cyanoethyl-2-methylimidazole, 1-cyanoethyl-2-ethyl-4-methylimidazole or mixtures thereof.

4. The composition of claim 1, wherein the one or more diluents are selected from the group consisting of glycidyl ethers, 1,4-butanediol diglycidyl ether; p-tert-butyl-phenyl glycidyl ether, allyl glycidyl ether, glycerol diglycidyl ether, glycidyl ether of alkyl phenol and mixtures thereof.

5. The composition of claim 1, wherein the thermally conductive particles are selected from the group consisting of silica, alumina, nano silica, nano alumina, zinc oxide, magnesium oxide, boron nitride, aluminum nitride,.

6. The composition of claim 1, wherein at least a portion of the thermally conductive particles have a length to width aspect ratio of greater than 1.0

7. The composition of claim 6, wherein the length to width aspect ratio is in the range of greater than 1.0 to about 2.5.

8. The composition of claim 1, wherein at least a portion of the thermally conductive particles have a geometrically smooth surface.

9. The composition of claim 1 further comprising one or more of the group consisting of surface active agents, surfactants, wetting agents, antioxidants, thixotropes, reinforcement materials, silane functional perfluoroether, phosphate functional perfluoroether, silanes, titanates, wax, phenol formaldehyde, air release agents, flow additives, adhesion promoters, rheology modifiers, surfactants, spacer beads and mixtures thereof.

10. The composition of claim 1, wherein the composition is in the form of a paste.

11. The composition of claim 1, wherein the one or more curable resins comprise in the range of about 5 to about 40 weight percent of the composition.

12. The composition of claim 1, wherein the one or more curing agents comprise in the range of about 0.1 to about 30 weight percent of the composition.

13. The composition of claim 2, wherein the one or more diluents comprise in the range of about 2 to about 20 weight percent of the composition.

14. The composition of claim 1, wherein the one or more thermally conductive particles comprise in the range of about 25 to about 95 weight percent of the composition.

15. An adhesive for use in electronic devices comprising the thermally conductive composition of claim 1.

16. A thermal interface material for use in electronic devices comprising the thermally conductive composition of claim 1.

17. An encapsulant for use in electronic devices comprising the thermally conductive composition of claim 1.

18. An anti-corrosion composition for use in electronic devices comprising the thermally conductive composition of claim 1.

19. An electronic device comprising the thermally conductive composition of claim 1.

20. A method of transferring heat from in one or more electronic components utilizing the thermally conductive composition of claim 1.
